# EUROPEAN PATENT APPLICATION

(11) **EP 2 085 938 A1**
(43) Date of publication of application: **05.08.2009**
(21) Application number: 06841704.7
(22) Date of filing: 24.11.2006
(51) Int. Cl.: G08B 13/22, G08B 13/186, H01L 31/042

(54) **ANTI-THEFT DEVICE FOR SOLAR PANELS**

(71) Applicant: Ingeteam Energy, S.A., 31621 Sarriguren (Navarra) (ES)
(72) Inventor: COLOMA CALAHORRA, Javier, 31006 Pamplona (ES); MARROYO PALOMO, Luis, 31008 Pamplona (ES)
(74) Representative: Carpintero Lopez, Francisco
(86) International application number: PCT/ES2006/000651
(87) International publication number: WO 2008/062076

(57) **Abstract**

The invention constitutes a theft protection system for photovoltaic panels of a solar installation, of great effectiveness, simple and economic. The device consists of at least one cable (2) which is made to pass through all the solar panels (1) of the installation. This cable (2) may be fibre optic or electrical, and a light beam or an electrical current, respectively, is made to circulate therethrough. At the ends of the cable (2), an electrical control circuit (3) is connected, capable of detecting a cut in the cable (2), on causing the interruption of the light beam in the fibre or a voltage drop at the ends of the electrical cable. Theft of the panel involves cutting the cable (2) which joins, traversing or adhered to its rear part, all the panels (1), this action being detected by the control circuit (3) which activates an alarm, acoustic and/or visual, which may belong to the solar installation or be remote.

## Description

### OBJECT OF THE INVENTION

The present invention has its main field of application in the industry intended for the design of electronic devices and, more particularly, to those devised within the sector of photovoltaic solar power systems.

The object of the invention is to provide a protection to the photovoltaic generators of total effectiveness and simple installation to avoid theft in the solar installations, without the need to resort to other additional surveillance measures or increase the prices of the generator or the overall cost of the installation.

### BACKGROUND OF THE INVENTION

The main element of any photovoltaic installation is the photovoltaic generator, formed by an array of photovoltaic panels or modules, which transform the light energy from the sun into electrical energy. Although in recent years photovoltaic panels have become considerably cheaper mainly due to the increase in the total power installed, the prices of each module continues to be high and represents a very important part within the cost of a photovoltaic installation.

The location of many of the installations in isolated places, without surveillance, together with the high cost of photovoltaic panels, has encouraged the theft of panels. These thefts endanger the installations economic feasibility, it being necessary to implement deterrent systems and take out insurance policies against theft which makes the installation considerably more expensive.

This frequent situation of theft or unauthorized use of the photovoltaic modules of the installation have promoted the search for effective anti-theft solutions to protect the photovoltaic panels. In this sense, patent WO00/19580 is noteworthy, which contemplates a protection against the fraudulent use of the solar installation based on the transmission of signals to validate an authorized user. In the system disclosed in WO00/19580, each photovoltaic module is physically associated to a converter which is in also in charge of making it work at its point of maximum power, enabling the extraction of power from the panel only when the correct code is entered. A similar safety system against theft is also disclosed in patent application WO2004/090993, although in this case it is not a converter but a disconnection system and power lines are also used to transmit the access code. The main drawback of these alternatives is that each module of the photovoltaic panel must carry an anti-theft system which makes the installation more expensive.

On the other hand, an attempt has been made to reduce the theft of panels by the use of special fastening means, such as round headed screws, to fasten the panels to the main structure. It is a simple and cheap method to mitigate the problem, hindering the dismantling of the panels. However, thefts in installations equipped with these systems continue to occur.

In large installations or groups of installations close together, surveillance systems have been used with security personnel, video surveillance cameras, etc. These measures are effective but they make the photovoltaic installation maintenance considerably more expensive.

### DESCRIPTION OF THE INVENTION

The present invention presents a novel anti-theft device which is based on the "sewing" of all the panels of a solar installation, so that in the case of an alteration, due to the unauthorized manipulation of one of said panels or to the attempt at theft thereof, a local and/or remote signal is activated which deters the thieves.

In particular, the anti-theft device for solar panels proposed herein comprises at least one cable, electrical or fibre optic, which is joined to each solar panel of the photovoltaic generator of the installation. The cable can be joined to each solar panel by making it pass through holes provided in the panel framework, or instead, be adhered to the rear surface of said panel, running along each one of the panels to be protected, which thus remain "sewn" together.

The two ends of the cable are connected to a control circuit which is capable of detecting any manipulation in the cable and, in consequence, activate at least one visual and/or sound alarm, which can be connected to the control circuit or whereby the control circuit connects via a wireless link, or it is also possible to simultaneously actuate two types of alarm, local and remote, for greater security.

On removing a solar panel from the installation with the intention of stealing it, it is necessary to cut the cable which joins all the panels, being detected by the electronic control circuit which activates the alarm(s).

### DESCRIPTION OF THE DRAWINGS

To complement the description being made and in order to aid towards a better understanding of the characteristics of the invention, in accordance with a preferred example of practical embodiment thereof, a set of drawings is attached as an integral part of said description, wherein with illustrative and non-limitative character, the following has been represented:

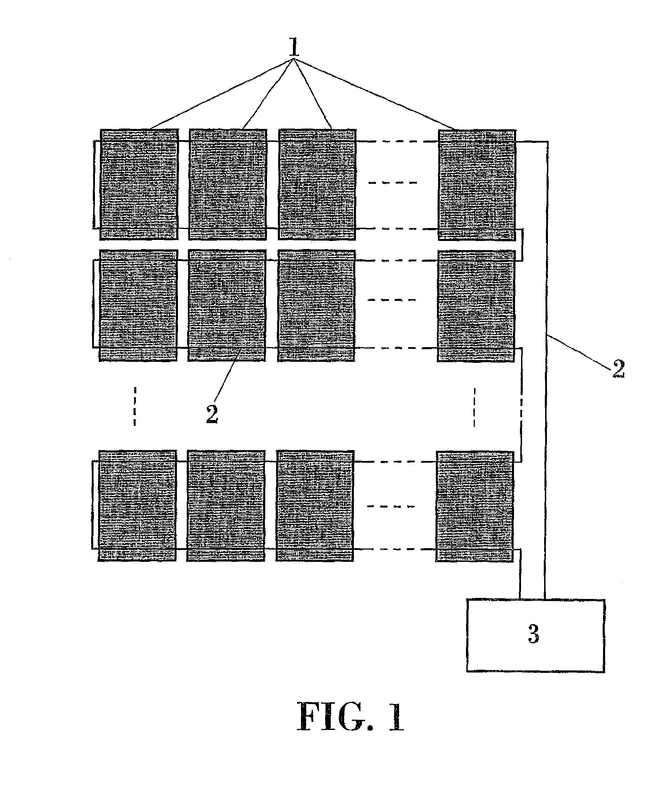

Figure 1. Shows a schematic representation of the device object of the invention associated to an installation of photovoltaic panels, comprising an anti-theft cable connected to a control circuit which detects a cut in the cable and actuates an alarm.

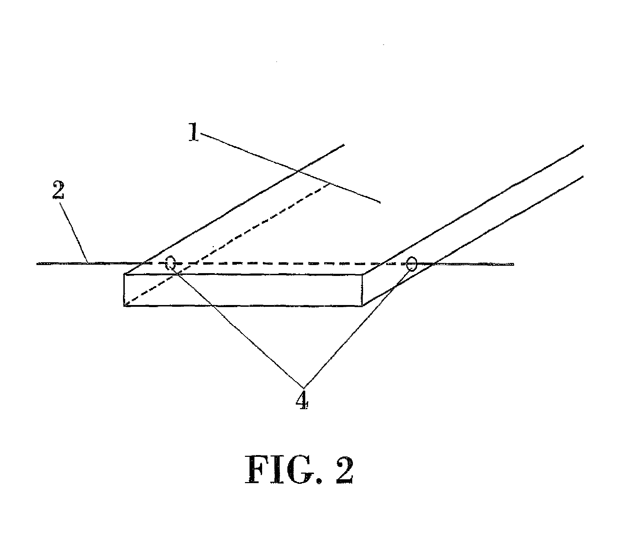

Figure 2. Shows a detail of the anti-theft cable passing through the panels, according to a preferred embodiment of the invention.

### PREFERRED EMBODIMENT OF THE INVENTION

In light of the figures indicated, a first preferred practical embodiment of the invention can be described as an anti-theft device for an installation of multiple solar panels (1), comprising at least one cable (2) which runs through each solar panel (1) through orifices (4) made in the framework of the panel (1), each panel (1) being traversed by said cable (2) at least once. The ends of the cable (2) are connected to a control circuit (3) which has means for the detection of the manipulation of the cable (2) connected to means of actuation of an alarm, which may act on an alarm generator belonging or connected to the same control circuit (3) or effect a remote activation of an alarm provided in another place.

In this option of embodiment, the cable (2) is one of electrical current. In this case, the control circuit (3) comprises a power source connected to one end of the cable (2) and adapted to inject current into said cable (2). The means of detection of the manipulation of the cable (2) consist of at least one electrical voltage drop detector adapted to actuate the alarm generation means in the event of the voltage drop detected. Thus, the current generator of the control circuit (3) injects it into the cable (2) so that that its ends there appears a fixed voltage drop due to the resistance of the cable (2). In the case of cutting the cable, the voltage difference between these ends varies and the control circuit (3) detects this voltage variation, by means of a binary logic or by an electrical differential, activating the alarm.

In a possible embodiment of the invention, it is proposed to randomly distribute a series of resistances of a value determined by the cable (2) to avoid performing a bridge at its ends, since it is achieved that the resistance throughout the cable is not uniform hindering its cutting and bridging for the theft of any of the panels (1).

Another alternative embodiment consists of the "sewing" of the panels by a cable (2) which is an optical fibre. In this case, the control circuit (3) comprises a light source connected to one end of the cable (2) and adapted to inject a light beam into said cable (2). If anyone should cut the cable to take the panels (1), the light beam would be interrupted. The means of detection of the manipulation of the cable (2) consist of at least one optical sensor connected to the other of the cable (2) joined to the emitter or light source. The interruption of the beam by cutting the cable (2) is detected by the control circuit (3) which activates the alarm. Optical fibre is immune to electromagnetic disturbances that the equipment close by may introduce, which gives robustness to the device. On the other hand, with the fibre optic an external bridge cannot be made, obtaining a greater degree of security. Furthermore, the energy consumption is greatly reduced.

The terms in which this specification has been written must always be taken in the broadest and non-limitative sense.

## Claims

1. Anti-theft device for solar panels (1), **characterized in that** it comprises at least one cable (2) which is joined to each solar panel (1) and connected by its ends to a control circuit (3) which comprises means for the detection of a manipulation of the cable (2) and means of alarm actuation connected to said means of detection of manipulation of the cable (2).

2. Device according to claim 1, **characterized in that** the cable (2) is optical fibre.

3. Device according to claim 2, **characterized in that** the control circuit (3) comprises a light source connected to one end of the cable (2), and adapted to inject a light beam to said cable (2), and **in that** the means of detection of the manipulation of the cable (2) consist of at least one optical sensor connected to the opposite end of said cable (2) and adapted to detect the cutting of the light beam.

4. Device according to claim 1, **characterized in that** the cable (2) is of electrical current.

5. Device according to claim 4, **characterized in that** the control circuit (3) comprises a power source connected to one end of the cable (2) and adapted to inject current into said cable (2), and **in that** the means of detection of the manipulation of the cable (2) consist of at least one adapted electrical voltage drop detector.

6. Device according to claim 5, **characterized in that** the means of detection of the manipulation of the cable (2) consist of at least one electrical differential connected to the cable (2).

7. Device according to any of claims 4, 5 or 6, **characterized in that** it comprises a plurality of electrical resistances connected according to a random distribution throughout the cable (2).

8. Device according to any of the preceding claims, **characterized in that** the cable (2) traverses each solar panel (1) through at least one part, which has at last one pair of orifices (4) provided for the passage of said cable (2).

9. Device according to any of claims 1 to 8, **characterized in that** the cable (2) is adhered to the rear part of each solar panel (1).

10. Device according to any of the preceding claims, **characterized in that** the means of actuation of the alarm act in the event of detection of a manipulation in the cable (2) on at least one local alarm connected to the control circuit (3).

11. Device according to any of the preceding claims, **characterized in that** the means of actuation of the alarm act in the event of detection of a manipulation in the cable (2) on at least one remote alarm through means of wireless connection provided in the control circuit (3).
